# EUROPÄISCHE PATENTSCHRIFT

(11) **EP 2 823 507 B1**
(45) Veröffentlichungstag und Bekanntmachung des Hinweises auf die Patenterteilung: **29.07.2020**
(21) Anmeldenummer: 13702433.7
(22) Anmeldetag: 29.01.2013
(51) Int. Cl.: H01L 21/285, H01L 21/04, H01L 29/66

(54) **VERFAHREN ZUM BILDEN EINES KONTAKTS AUF EINEM HALBLEITERSUBSTRAT UND HALBLEITERVORRICHTUNG**
METHOD OF FORMING A CONTACT ON A SEMICONDUCTOR SUBSTRATE AND CORRESPONDING DEVICE
PROCÉDÉ DE FABRICATION D'UN CONTACT SUR UN SUBSTRAT SEMICONDUCTEUR ET DISPOSITIF CORRESPONDANT

(30) Priorität: 05.03.2012 DE 102012203443
(43) Veröffentlichungstag der Anmeldung: 14.01.2015
(73) Patentinhaber: Robert Bosch GmbH, 70442 Stuttgart (DE)
(72) Erfinder: SUENNER, Thomas, 70178 Stuttgart (DE); GRIEB, Michael, 71229 Leonberg (DE)
(86) Internationale Anmeldenummer: PCT/EP2013/051684
(87) Internationale Veröffentlichungsnummer: WO 2013/131690

(56) Entgegenhaltungen:
- WO-A1-2010/095544
- JP-A- 2005 276 978
- US-A1- 2009 236 676
- US-A1- 2010 244 048

## Beschreibung

Die Erfindung betrifft ein Verfahren zum Bilden eines Kontakts auf einem Halbleitersubstrat.

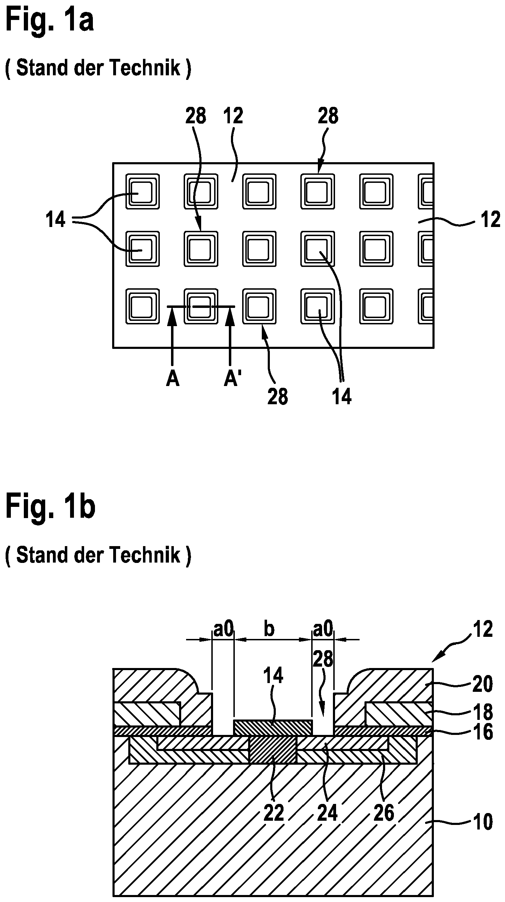

Fig. 1a und 1b zeigen schematische Darstellungen einer Halbleitervorrichtung gemäß dem Stand der Technik.

Die in Fig. 1a und 1b schematisch wiedergegebene herkömmliche Halbleitervorrichtung kann beispielsweise mittels des in der DE 10 2010 030 850 A1 beschriebenen Verfahrens gebildet werden. Die Halbleitervorrichtung umfasst einen Siliziumkarbid-Träger 10, auf dessen Oberseite eine Gate-Stapel-Struktur 12 und eine Vielzahl von leitfähigen Kontakten 14 gebildet sind.

Mittels des Querschnitts entlang der Linie AA' der Fig. 1a ist in Fig. 1b der innere Aufbau der Gate-Stapel-Struktur 12 wiedergegeben. Die Gate-Stapel-Struktur 12 umfasst bei dem dargestellten Ausführungsbeispiel eine auf die Oberseite des Siliziumkarbid-Trägers 10 aufgebrachte Gateoxidschicht 16, eine die Gateoxidschicht 16 zumindest teilweise abdeckende Gatemetallisierungsschicht 18 und eine auf die Schichten 16 und 18 aufgebrachte Isolierschicht 20. Mittels der Implantationen 22 bis 26 in unterschiedlichen Konzentrationen ist jeder der Kontakte 14 mit der Gate-Stapel-Struktur 12 elektrisch verbunden. Außerdem ist jeder der Kontakte 14 in einer Öffnung 28 in der Gate-Stapel-Struktur 12 angeordnet. Das nass- oder trockenchemische Strukturieren der Kontakte 14 in den Öffnungen 28 ist nach dem Stand der Technik möglich, indem zwischen einem Rand jeder Öffnung 28 und einem Rand einer (nicht wiedergegebenen) Lithographiemaske jeweils ein Abstand a0 eingehalten wird. Der Abstand a0 liegt mindestens über 20 nm, meistens über 50 nm, in der Regel über 100 nm. Der Abstand a0 ist vergleichsweise groß zu einer parallel zu der Oberseite des Siliziumkarbid-Trägers 10 ausgerichteten Ausdehnung b eines jeden Kontakts 14.

Außerdem beschreibt die WO 2010/095544 A1 ein Verfahren zum Herstellen einer Halbleitervorrichtung. Zum Bilden von Kontakten der späteren Halbleitervorrichtung wird ein Metallfilm auf den Flächen der späteren Kontakte und auf einer die Flächen umrahmenden Isolierschicht abgeschieden und anschließend auf eine Temperatur zwischen 300°C und 800°C erhitzt. Danach werden Reste des Metallfilms mittels eines chemischen Ätzschritts entfernt.

### Offenbarung der Erfindung

Die Erfindung schafft ein Verfahren zum Bilden eines Kontakts auf einem Halbleitersubstrat mit den Merkmalen des Anspruchs 1.

### Vorteile der Erfindung

Durch das Ausführen des erfindungsgemäßen Verfahrens können quasi-selbstjustierte Kontakte ohne eigene Lithographieebene hergestellt werden. Wahlweise können sie auch mit einer Lithographieebene mit geringen Anforderungen an die Justage und geringen Anforderungen an den Ätzvorhalt strukturiert werden. Indem zwischen dem Aufbringen des mindestens einen Metalls und dem Erhitzen des Halbleitersubstrats mindestens ein lonenstrahlätzschritt in einer Ätzrichtung, welche geneigt zu einer senkrecht zu der Außenseite des Halbleitersubstrats ausgerichteten Achse ist, ausgeführt werden, kann eine grobe Strukturierung des mindestens einen Metalls vor dem Erhitzen des Halbleitersubstrats erfolgen, wodurch verhinderbar ist, dass das mindestens eine Metall während des Erhitzens an unerwünschten Stellen mit dem Material des Halbleitersubstrats oder mindesten einem darauf aufgebrachten Stoff reagiert. Insbesondere kann das Verfahren zur Herstellung der vorteilhaften Halbleitervorrichtung angewandt werden. Somit kann das Verfahren zum Realisieren eines relativ geringen Abstands kleiner als 10 nm zwischen einer Gate-Stapel-Struktur und mindestens einem Kontakt genutzt werden. Durch die Ausbildbarkeit eines signifikant reduzierten Abstands zwischen dem mindestens einen Kontakt und der Gate-Stapel-Struktur kann die Halbleitervorrichtung mit einer kleineren Ausdehnung parallel zu der mit mindestens einem Kontakt versehenen Substratoberfläche realisiert werden. Durch die auf diese Weise gewonnen Materialeinsparung, wie beispielsweise Einsparung des Substratmaterials, ist die vorteilhafte Halbleitervorrichtung billiger herstellbar. Außerdem erleichtert die kleinere Ausbildbarkeit der Halbleitervorrichtung deren Transport, Anbringung und Verwendung. Des Weiteren kann die Realisierung eines kleineren Abstands zwischen der mindestens einen Gate-Stapel-Struktur und dem mindestens einen Kontakt auch für eine höhere Zellenkonzentration auf einer Fläche der mit den Kontakten bestückten Substratoberfläche genutzt werden. In diesem Fall kann die vorliegende Erfindung auch zum Reduzieren eines Durchlasswiderstands eines Transistors genutzt werden.

In einer vorteilhaften Ausführungsform des Verfahrens wird mindestens einer der Kontakte in einem Abstand zu mindestens einer Gate-Stapel-Struktur gebildet, welcher kleiner als 10 nm ist, wobei die Gate-Stapel-Struktur eine auf dem Halbleitersubstrat abgeschiedene Gateoxidschicht, eine die Gateoxidschicht teilweise abdeckende Gatemetallisierungsschicht und die auf die Gate-Stapel-Struktur und die Gatemetallisierungsschicht aufgebrachte Isolierschicht umfasst. Bei der Ausführung des Verfahrens kann somit auf einen Justage- oder Ätzvorhalt verzichtet werden.

Beispielsweise können Nickel, Titan, Aluminium, Tantal und/oder Wolfram als das mindestens eine Metall aufgebracht werden. Das vorteilhafte Verfahren ist somit zum Bilden einer Vielzahl von Kontakten aus verschiedenen Materialien geeignet.

Insbesondere können vor dem Aufbringen des mindestens einen Metalls die Isolierschicht auf zumindest einer Teilaußenseite der Außenseite des Halbleitersubstrats und/oder der auf das Halbleitersubstrat aufgebrachten Schicht gebildet und die mindestens eine Teilfläche der Außenseite des Halbleitersubstrats und/oder der auf das Halbleitersubstrat aufgebrachten Schicht an mindestens einer Stelle des zu bildenden mindestens einen Kontakts freigelegt werden. Beispielsweise kann zumindest eine Siliziumoxidschicht und/oder eine Siliziumnitridschicht als die Isolierschicht gebildet werden. Somit können kostengünstige und einfache verarbeitbare Materialien für die Isolierschicht verwendet werden.

Ebenso kann eine auf dem Halbleitersubstrat abgeschiedene Gateoxidschicht und eine die Gateoxidschicht teilweise abdeckende Gatemetallisierungsschicht von der Isolierschicht abgedeckt werden. Auf diese Weise kann die abgedeckte Komponente während des Erhitzens des Halbleitersubstrats verläßlich vor einem Kontakt mit dem mindestens einen Metall geschützt werden. Außerdem kann die eine Gate-Stapel-Unterstruktur abdeckende Isolierschicht zum Vervollständigen der Gate-Stapel-Struktur als Untereinheit von dieser genutzt werden. Mittels dieser Multifunktionalität der Isolierschicht können Verfahrensschritte und Materialien eingespart werden. Beispielsweise kann das Substrat während des Erhitzens auf eine Temperatur von mindestens 600°C erwärmt werden. Ein derartiger Verfahrensschritt ist mittels eines Ofens einfach und schnell ausführbar.

In einer vorteilhaften Ausführungsform wird ein isotoper Ätzschritt als der Ätzschritt unter Verwendung des Ätzmaterials mit der höheren Ätzrate für das mindestens eine Metall als für das Halbleiter-Metall-Material ausgeführt. Der Ätzschritt ist somit einfach und innerhalb einer vergleichsweise kurzen Zeit ausführbar.

Beispielsweise wird mindestens ein Sourcekontakt als der mindestens eine Kontakt gebildet. Dies ist vorteilhaft, da insbesondere bei einem MOSFET ein kleinerer Abstand zwischen jedem Sourcekontakt und einer benachbarten Gate-Stapel-Struktur erwünscht ist. Die Ausführbarkeit des hier beschriebenen Verfahrens ist jedoch nicht auf die Herstellung von Sourcekontakten limitiert.

### Kurze Beschreibung der Zeichnungen

Weitere Merkmale und Vorteile der vorliegenden Erfindung werden nachfolgend anhand der Figuren erläutert. Es zeigen:
- Fig. 1a und 1b: schematische Darstellungen einer Halbleitervorrichtung gemäß dem Stand der Technik;
- Fig. 2: ein Flussdiagramm zum Darstellen eines Verfahrens zum Bilden eines Kontakts auf einem Halbleitersubstrat, welches nicht unter die vorliegende Erfindung fällt;
- Fig. 3: einen schematischen Querschnitt durch ein Halbleitersubstrat zum Erläutern einer Ausführungsform des Verfahrens zum Bilden eines Kontakts auf einem Halbleitersubstrat; und
- Fig.4: eine schematische Draufsicht auf eine Halbleitervorrichtung, welche nicht unter die vorliegende Erfindung fällt.

### Ausführungsformen der Erfindung

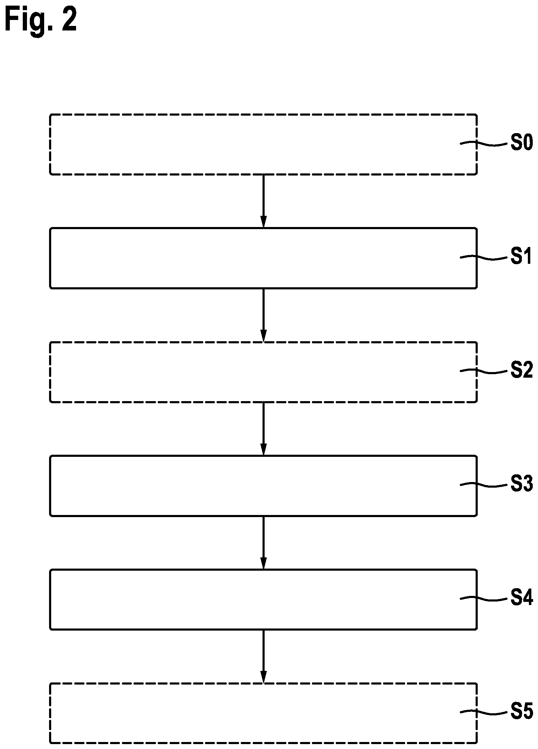

Fig. 2 zeigt ein Flussdiagramm zum Darstellen eines Verfahrens zum Bilden eines Kontakts auf einem Halbleitersubstrat, welches nicht unter die vorliegende Erfindung fällt.

In einem optionalen Verfahrensschritt S0 können später mit dem mindestens einen gebildeten Kontakt zusammenwirkende Strukturen auf dem Halbleitersubstrat ausgebildet werden. Beispielsweise kann mindestens eine Implantation in dem Halbleitersubstrat eingebracht werden. Ebenso kann mindestens ein Material auf dem Halbleitersubstrat abgeschieden werden. Insbesondere kann mindestens eine Gate-Stapel-Struktur und/oder mindestens eine Gate-Stapel-Unterstruktur auf dem Halbleitersubstrat gebildet werden. Dazu können eine Gateoxidation durchgeführt und/oder eine Gatemetallisierung, wie beispielsweise Polysilizium, abgeschieden werden.

Außerdem kann eine Isolierschicht in dem Verfahrensschritt S0 auf zumindest einer Teilaußenseite der Außenseite des Halbleitersubstrats und/oder einer auf das

Halbleitersubstrat aufgebrachten Schicht gebildet werden. Beispielsweise können zumindest eine Siliziumoxidschicht und/oder eine Siliziumnitridschicht als die Isolierschicht gebildet werden. Insbesondere kann die Isolierschicht ein Hochtemperaturoxid umfassen, welches bei einer Temperatur zwischen 600°C bis 1000°C gebildet wird. Außerdem können DCS und Stickstoffoxid (N₂O) als Ausgangsmaterialien zum Bilden der Isolierschicht verwenden werden. Anstelle der hier aufgezählten Beispiele können jedoch auch andere Materialien zum Bilden der Isolierschicht eingesetzt werden.

Mindestens eine Gate-Stapel-Struktur und/oder mindestens eine Gate-Stapel-Unterstruktur können von der Isolierschicht abgedeckt werden. Sofern mindestens eine Gate-Stapel-Unterstruktur von der Isolierschicht abgedeckt wird, können zumindest Bereiche der Isolierschicht auch als Untereinheit der damit gebildeten Gate-Stapel-Struktur genutzt werden. Durch diese Multifunktionalität der Isolierschicht können Materialien und/oder Verfahrensschritte eingespart werden.

In dem Verfahrensschritt S0 kann auch mindestens eine Teilfläche der Außenseite des Halbleitersubstrats und/oder der auf das Halbleitersubstrat aufgebrachten Schicht an mindestens einer Stelle des zu bildenden mindestens einen Kontakts von der zuvor gebildeten Isolierschicht freigelegt werden. Für die Strukturierung der Isolierschicht können herkömmliche Strukturierschritte ausgeführt werden.

In einem Verfahrensschritt S1 wird mindestens ein Metall auf mindestens eine freiliegende Teilfläche der Außenseite des Halbleitersubstrats und/oder der auf das Halbleitersubstrat aufgebrachten Schicht aufgebracht. Bei dem Aufbringen des mindestens einen Metalls wird mindestens ein Randbereich der Isolierschicht, welcher die (zuvor freiliegende) Teilfläche umrahmt, zumindest teilweise mit dem mindestens einen Metall bedeckt. Somit kann das Aufbringen des mindestens einen Metalls vergleichsweise grobflächig erfolgen. Beispielsweise können Nickel, Titan, Aluminium, Tantal und/oder Wolfram als das mindestens eine Metall aufgebracht werden. Zum Aufbringen des mindestens einen Metalls kann dieses auf das insbesondere unmaskierte Halbleitersubstrat gesputtert werden. Der Verfahrensschritt S1 ist somit einfach und schnell ausführbar.

In einem optionalen Verfahrensschritt S2 kann das mindestens eine aufgebrachte Metall grob strukturiert werden. Beispielsweise kann dies durch einen Lithographieschritt und eine nasschemische Ätzung erfolgen. Es wird darauf hingewiesen, dass der Verfahrensschritt S2 zum Ausführen des Verfahrens nicht notwendig ist. Auf diesen Strukturierungsschritt kann insbesondere verzichtet werden, wenn alle vor einer Reaktion mit dem mindestens einen Metall zu schützenden Strukturen auf der Außenseite von der Isolierschicht bedeckt sind. Sofern der Verfahrensschritt S2 ausgeführt wird, ist ein grobes Strukturieren des mindestens einen Metalls ausreichend. Es wird insbesondere darauf hingewiesen, dass es nicht notwendig ist, den mindestens einen Randbereich der Isolierschicht von dem mindestens einen Metall freizulegen.

In einem nach dem Verfahrensschritt S1 oder S2 ausgeführten Verfahrensschritt S3 wird das Halbleitersubstrat mit dem auf die mindestens eine Teilfläche und dem mindestens einen Randbereich aufgebrachten mindestens einen Metall erhitzt. Durch das Erhitzen wird eine Reaktion des auf der mindestens einen Teilfläche aufgebrachten mindestens einen Metalls mit mindestens einem Halbleitermaterial der mindestens einen Teilfläche zu einem Halbleiter-Metall-Material (als Endmaterial oder Weiterverarbeitungsmaterial mindestens eines Kontakts) angeregt.

Während des Erhitzens kann das Halbleitersubstrat auf eine Temperatur von mindestens 600°C erwärmt werden. Beispielsweise wird das Halbleitersubstrat auf eine Temperatur um 1000°C für eine Dauer von etwa 2 Minuten erhitzt. Die während des Erhitzens einzuhaltende Temperatur und die Dauer dieses Verfahrensschritts können unter Berücksichtigung des mindestens einen aufgebrachten Metalls und/oder des Halbleitermaterials der mindestens einen Teilfläche relativ frei gewählt werden. Das Erhitzen des Halbleitersubstrats mit dem auf der mindestens einen Teilfläche und dem mindestens einen Randbereich aufgebrachten mindestens einen Metall kann beispielsweise durch einen Rapid-Thermal-Anneal-Prozessschritt erfolgen.

Beispielsweise können während des Erhitzens das mindestens eine Metall und das mindestens eine Halbleitermaterial zu dem Endmaterial des späteren mindestens einen Kontakts reagieren. Als Alternative dazu kann auch ein Weiterverarbeitungsmaterial entstehen, zu welchem das mindestens eine Metall und das mindestens eine Halbleitermaterial miteinander reagieren, welches in einem weiteren (nicht beschriebenen) Verfahrensschritt mit mindestens einem anderen Stoff zu dem Endmaterial des mindestens einen Kontakts reagiert. Durch das Erhitzen kann auch das ohmsche Verhalten des mindestens einen zu diesem Zeitpunkt oder später gebildeten Kontakts ausgebildet werden. Sofern dies gewünscht wird, kann eine zum Ausbilden des ohmschen Verhaltens ausreichend hohe Temperatur während des Erhitzens eingestellt werden. Eine alternative Vorgehensweise dazu wird unten noch beschrieben.

Während des Erhitzens des Halbleitersubstrats mit dem auf der mindestens einen Teilfläche und den mindestens einen Randbereich aufgebrachten mindestens einen Metall kann das mindestens eine Metall teilweise mit der Isolierschicht reagieren. Der Verbrauch des Isoliermaterials der Isolierschicht ist jedoch im Allgemeinen vernachlässigbar gering. Sofern die Isolierschicht auch nach dem Bilden des mindestens einen Kontakts noch eine Funktion ausführen soll, kann der Verbrauch durch ein Ausbilden der Isolierschicht mit einer geringfügig gesteigerten Dicke, beispielsweise um 40 nm, leicht kompensiert werden.

Nach dem Verfahrensschritt S3 wird ein Ätzschritt als Verfahrensschritt S4 ausgeführt. Dies erfolgt unter Verwendung eines Ätzmaterials mit einer höheren Ätzrate für das mindestens eine Metall als für das Halbleiter-Metall-Material. Der in dem Verfahrensschritt S4 ausgeführte Ätzschritt kann insbesondere ein isotoper Ätzschritt sein. Es wird darauf hingewiesen, dass eine Vielzahl von Ätzmaterialien zum Ausführen des Verfahrensschritts S4 nutzbar ist. Die Auswahl des Ätzmaterials kann unter Berücksichtigung des mindestens einen Metalls und des Halbleiter-Metall-Materials relativ frei gewählt werden. Beispielsweise kann das als das mindestens eine Metall verwendete Nickel in dem Verfahrensschritt S4 mit einer Mischung aus Phosphor- und Salpetersäure leicht entfernt werden. Dabei können Restspuren des mindestens einen Metalls auf einer Außenoberfläche der Isolierschicht verbleiben. Diese Restspuren können insbesondere auch Bindungen aus dem mindestens einen Metall und dem Isoliermaterial der Isolierschicht sein.

Das mittels der oben beschriebenen Verfahrensschritte hergestellte Halbleitersubstrat kann mittels bekannter Verfahren weiter bearbeitet werden.

Der mittels des oben beschriebenen Verfahrens gebildete mindestens eine Kontakt kann in einem parallel zu der mit dem mindestens einen Kontakt bestückten Halbleiteroberfläche ausgerichteten Abstand zu mindestens einer Gate-Stapel-Struktur gebildet werden, welcher kleiner als 10 nm ist. Insbesondere kann der Abstand kleiner als 5 nm sein. Somit kann mittels des oben beschriebenen Verfahrens eine Anordnung des mindestens einen gebildeten Kontakts an mindestens einer Gate-Stapel-Struktur realisiert werden, welche eine vorteilhafte hohe Zellendichte auf der Halbleiteroberfläche gewährleistet.

In einer besonders vorteilhaften Ausführungsform wird mindestens ein Sourcekontakt als der mindestens eine Kontakt gebildet. Der Sourcekontakt kann beispielsweise auf einem Siliziumkarbid-Substrat ausgebildet werden. Somit kann mittels des Verfahrens ein Leistungshalbleiter (MOSFET) ohne einen Strukturierungsschritt zum Strukturieren des Sourcekontakts gebildet werden. Man kann deshalb auch von einem selbstjustierten Herstellungsprozess des mit Sourcekontakten ausgestatteten Leistungshalbleiters sprechen.

Die Verwendbarkeit des hier beschriebenen Verfahrens ist jedoch nicht auf einen Leistungshalbleiter mit Sourcekontakten limitiert. Stattdessen kann eine Vielzahl von elektrischen Bauteilen mittels des hier beschriebenen Verfahrens hergestellt werden.

In einer vorteilhaften Weiterbildung des Verfahrens wird das mindestens eine abgeschiedene Metall während des Verfahrensschritts S3 auf eine vergleichsweise niedrigere Temperatur zwischen 500°C bis 800°C in einem ersten Ofenprozess erhitzt. Durch diesen ersten Ofenprozess kann das mindestens eine Metall mit dem Halbleitermaterial, wie beispielsweise Siliziumkarbid, reagieren, ohne dass das Reaktionsprodukt ohmsch/gut leitfähig wird. Durch die niedrige Temperatur kann die Wahrscheinlichkeit einer Reaktion zwischen dem mindestens einen Metall und dem Isoliermaterial der Isolierschicht reduziert werden. Anschließend kann das übrig gebliebene mindestens eine Metall in dem Verfahrensschritt S4 entfernt werden. Danach kann als optionaler Verfahrensschritt S5 ein zweiter Ofenprozess ausgeführt werden, um mittels einer höheren Temperatur eine ausreichend gute Leitfähigkeit des mindestens einen Kontakts zu gewährleisten. Der Vorteil dieser Vorgehensweise ist eine geringere Degradierung des Isoliermaterials der Isolierschicht während des Verfahrensschritts S3 bei Beibehaltung der niedrigen Kontaktwiderstände.

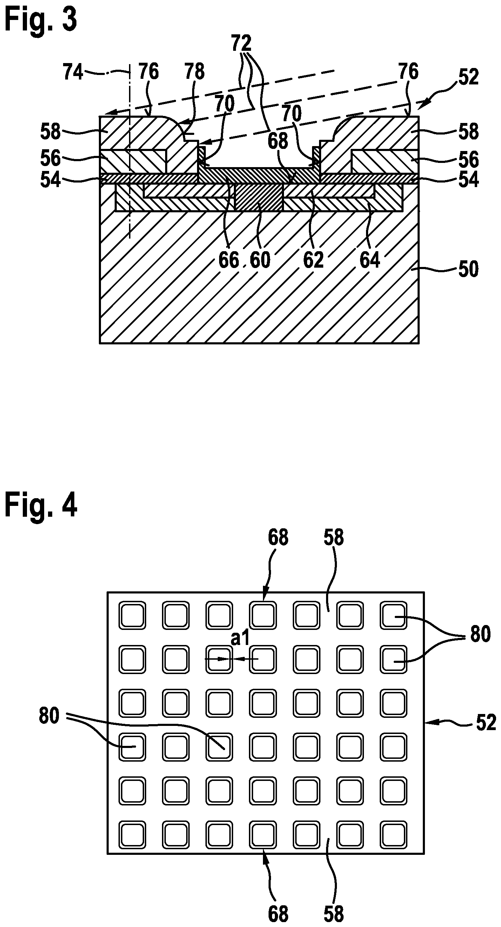

Fig. 3 zeigt einen schematischen Querschnitt durch ein Halbleitersubstrat zum Erläutern einer Ausführungsform des Verfahrens zum Bilden eines Kontakts auf einem Halbleitersubstrat.

In Fig. 3 ist ein Halbleitersubstrat 50 mit einer darauf ausgebildeten Gate-Stapel-Struktur 52 schematisch dargestellt. Das Halbleitersubstrat 50 kann beispielsweise ein Siliziumkarbid-Substrat sein. Die Ausführbarkeit des im Weiteren beschriebenen Verfahrens ist jedoch nicht auf die Verwendung von einem Siliziumkarbid-Substrat als Halbleitersubstrat 50 limitiert.

Zum Bilden der Gate-Stapel-Struktur 52 ist eine Gateoxidschicht 54 auf dem Halbleitersubstrat 50 abgeschieden. Die Gateoxidschicht 54 ist teilweise von einer Gatemetallisierungsschicht 56, beispielsweise aus Polysilizium, abgedeckt. Auf die Gateschichten 54 und 56 ist eine Isolierschicht 58, wie beispielsweise eine Siliziumoxidschicht und/oder Siliziumoxidschicht, aufgebracht. Die Ausbildung der Gate-Stapel-Struktur 52 aus den Schichten 54 bis 58 ist jedoch nur beispielhaft zu interpretieren.

Als Ergänzung zu der Gate-Stapel-Struktur 52 können noch Implantationen 60 bis 64 in das Halbleitersubstrat 50 eingebracht werden, mittels welchen eine elektrische Verbindung zwischen der Gate-Stapel-Struktur 52 und einem mittels des im weiteren beschriebenen Verfahrens gebildeten Kontakt ausbildbar ist. Die Konzentrationen und Ionen der Implantationen 60 bis 64 sind mit einer großen Designfreiheit wählbar.

Das Verfahren weist den oben schon beschriebenen Verfahrensschritt S1 auf, in welchem mindestens ein Metall, wie beispielsweise Nickel, Titan, Aluminium, Tantal und/oder Wolfram, abgeschieden wird. Auf diese Weise wird mindestens eine von den Schichten 54 bis 58 (noch) freiliegende oder freigelegte Teilfläche 68/Öffnung mit dem mindestens einen Metall 66 bedeckt. Das Aufbringen des mindestens einen Metalls 66 kann so grobflächig erfolgen, dass mindestens ein Randbereich 70 der Isolierschicht 58, welcher die mindestens eine Teilfläche 68 umrahmt, zumindest teilweise mit dem mindestens einen Metall 66 bedeckt wird. Optionaler Weise kann anschließend der oben schon beschriebene Verfahrensschritt S2 ausgeführt werden.

Nach dem Verfahrensschritt S1 oder S2 (d.h. zwischen dem Aufbringen des mindestens einen Metalls 66 und dem späteren Erhitzen des Halbleitersubstrats 50) wird bei der hier beschriebenen Ausführungsform des Verfahrens ein lonenstrahlätzschritt in einer Ätzrichtung 72, welche geneigt zu einer senkrecht zu einer Außenseite des Halbleitersubstrats 50 mit der darauf ausgebildeten Halbleiterstruktur 52 ausgerichteten Achse 74/Wafersenkrechten ist, ausgeführt. Die Ätzrichtung 72 kann zu der Achse 74/Wafersenkrechten um einen Winkel zwischen 5° bis 88°, vorzugsweise zwischen 30° bis 85°, bevorzugter Weise zwischen 60° bis 80°, geneigt ausgerichtet sein. Die Ausführbarkeit des in Fig. 3 dargestellten Verfahrensschritts ist nicht auf einen bestimmten Winkel beschränkt. Man kann dies auch als ein lonenstrahlätzen unter starker Verkippung zwischen dem entlang der Ätzrichtung 72 ausgerichteten lonenstrahl und der Achse 74/Wafersenkrechten umschreiben. Mittels eines derartigen lonenstrahlätzens/lonenstrahlätzschritts kann das mindestens eine Metall 66 auf einfache Weise grobflächig von der Gate-Stapel-Struktur 52 entfernt werden.

Allerdings wird das mindestens eine Metall 66 während des lonenstrahlätzens/lonenstrahlätzschritts lediglich von mindestens einer von dem Halbleitersubstrat 50 weggerichteten Oberseite 76 der Gate-Stapel-Struktur 52 und mindestens einem benachbart zu der Oberseite 76 liegenden Seitenwandbereich 78 der Gate-Stapel-Struktur 52 entfernt. Bezüglich der Teilfläche 68 und dem die Teilfläche 68 umrahmenden Randbereich 70 der Isolierschicht 58 fungiert die Gate-Stapel-Struktur 52 hingegen als Abschirmung, weshalb das mindestens eine Metall 66 nicht/kaum von der Teilfläche 68 und dem Randbereich 70 der Isolierschicht 58 entfernt wird. Man kann dies so umschreiben, dass das mindestens eine Metall 66 nicht oder nur teilweise von der als Grund einer Öffnung in der Gate-Stapel-Struktur 52 bezeichenbaren mindestens einen Teilfläche 68 und dem mindestens einen benachbarten Randbereich 70 entfernt wird.

Mittels des anhand der Fig. 3 erläuterten Verfahrensschritts kann das mindestens eine Metall 66 bereits vor dem Verfahrensschritt S3/der Kontaktlegierung von der mindestens einen Oberseite 76 und dem mindestens einen benachbarten Seitenwandbereich 78 der Gate-Stapel-Struktur 52 entfernt werden. Dies bewirkt, dass (nahezu) keine Restspuren des mindestens einen Metalls 66 nach dem nachfolgend aufgeführten Verfahrensschritten S3 und S4 auf der Isolierschicht 52 verbleiben. Auf diese Weise können eine verbesserte Haftung der Bondmetallisierung und eine erhöhte Zuverlässigkeit der mittels des Verfahrens hergestellten Halbleitervorrichtung gewährleistet werden.

Bezüglich der nachfolgend ausführbaren Verfahrensschritte S3 und S4 wird auf die vorhergehenden Ausführungen verwiesen.

Fig. 4 zeigt eine schematische Draufsicht auf eine Halbleitervorrichtung, welche nicht unter die vorliegende Erfindung fällt.

Die in Fig. 4 schematisch dargestellte Halbleitervorrichtung umfasst ein (nicht dargestelltes) Halbleitersubstrat und mindestens einen auf und/oder in mindestens einer Teilfläche 68 einer Außenseite des Halbleitersubstrats und/oder einer auf das Halbleitersubstrat aufgebrachten Schicht angeordneten Kontakt 80, welcher aus einem Halbleiter-Metall-Material gebildet ist. Außerdem weist die Halbleitervorrichtung auf der Außenseite des Halbleitersubstrats und/oder einer auf das Halbleitersubstrat aufgebrachten Schicht eine Gate-Stapel-Struktur 52 auf, welche benachbart zu dem mindestens einen Kontakt 80 angeordnet ist. Bezüglich der Materialien des Halbleitersubstrats, der Gate-Stapel-Struktur 52 und des mindestens einen Kontakts 80 wird auf die oberen Ausführungen verwiesen.

Ein parallel zu der Halbleiteroberfläche mit dem mindestens einen darauf ausgebildeten Kontakt 80 ausgerichteter Abstand a1 zwischen der mindestens einen Gate-Stapel-Struktur 52 und mindestens einem der Kontakte 80 ist kleiner als 10 nm. Insbesondere kann der Abstand a1 zwischen der mindestens einen Gate-Stapel-Struktur 52 und mindestens einem der Kontakte 80 kleiner als 5 nm sein. Anhand des vorteilhaft kleinen Abstands a1 ist erkennbar, dass die Halbleitervorrichtung mittels einer Ausführungsform des oben beschriebenen Verfahrens hergestellt ist. Bezüglich der von der Halbleitervorrichtung gewährleisteten Vorteile wird auf die oberen Ausführungen verwiesen.

Bei der dargestellten Ausführungsform wird der mindestens eine Kontakt 80 in dem Abstand a1 kleiner als 10 nm/5 nm von der mindestens einen Gate-Stapel-Struktur 52 umrahmt. Man kann dies auch so umschreiben, dass der mindestens eine Kontakt 80 in einer Öffnung in der mindestens einen Gate-Stapel-Struktur 52 in einem Abstand a1 kleiner als 10nm/5 nm dazu ausgebildet ist.

Die Herstellung der Halbleitervorrichtung mittels des oben beschriebenen Verfahrens kann auch daran erkennbar sein, dass der mindestens eine Kontakt 80 von einer die Gate-Stapel-Struktur 52 oder eine Gate-Stapel-Unterstruktur zumindest teilweise abdeckenden Isolierschicht 58 umrahmt ist, welche an ihrer Außenoberfläche Restspuren von Nickel, Titan, Aluminium, Tantal und/oder Wolfram aufweist. Die Restspuren können auch auf eine Verbindung der hier aufgezählten Metalle mit dem Isoliermaterial der Isolierschicht 58 zurückzuführen sein.

Zumindest der eine Kontakt 80 ist bei der dargestellten Ausführungsform ein Sourcekontakt. Die mittels der Fig. 4 wiedergegebene Halbleitervorrichtung ist jedoch nicht auf eine Ausstattung mit einem Sourcekontakt als dem mindestens einen Kontakt 80 limitiert.

## Patentansprüche

1. Verfahren zum Bilden eines Kontakts (80) auf einem Halbleitersubstrat (50) mit den Schritten:
Aufbringen mindestens eines Metalls (66) auf mindestens eine freiliegende Teilfläche (68) einer Außenseite des Halbleitersubstrats (50) und/oder einer auf das Halbleitersubstrat (50) aufgebrachten Schicht, wobei die Teilfläche (68) von mindestens einem Randbereich (70) einer Isolierschicht (58) umrahmt wird, und wobei der mindestens eine Randbereich (70) der Isolierschicht (58) zumindest teilweise mit dem mindestens einen Metall (66) bedeckt wird (S1);
Erhitzen des Halbleitersubstrats (50) mit dem auf der mindestens einen Teilfläche (68) und dem mindestens einen Randbereich (70) aufgebrachten mindestens einen Metall (66), wodurch das auf die mindestens eine Teilfläche (68) aufgebrachte mindestens eine Metall (66) mit mindestens einem Halbleitermaterial der mindestens einen Teilfläche (68) zu einem Halbleiter-Metall-Material als Endmaterial oder Weiterverarbeitungsmaterial des mindestens einen Kontakts (80) reagiert (S3); und
Ausführen eines Ätzschritts unter Verwendung eines Ätzmaterials mit einer höheren Ätzrate für das mindestens eine Metall (66) als für das Halbleiter-Metall-Material (S4)
**gekennzeichnet durch** den Schritt, dass
zwischen dem Aufbringen des mindestens einen Metalls (66) und dem Erhitzen des Halbleitersubstrats (50) mindestens ein lonenstrahlätzschritt in einer Ätzrichtung (72), welche geneigt zu einer senkrecht zu der Außenseite des Halbleitersubstrats (50) ausgerichteten Achse (74) ist, ausgeführt wird.

2. Verfahren nach Anspruch 1, wobei mindestens einer der Kontakte (80) in einem Abstand (a1) zu mindestens einer Gate-Stapel-Struktur (52) gebildet wird, welcher kleiner als 10 nm ist, wobei die Gate-Stapel-Struktur (52) eine auf dem Halbleitersubstrat (50) abgeschiedene Gateoxidschicht (54), eine die Gateoxidschicht (54) teilweise abdeckende Gatemetallisierungsschicht (56) und die auf die Gate-Stapel-Struktur (52) und die Gatemetallisierungsschicht (56) aufgebrachte Isolierschicht (58) umfasst.

3. Verfahren nach Anspruch 1 oder 2, wobei Nickel, Titan, Aluminium, Tantal und/oder Wolfram als das mindestens eine Metall (66) aufgebracht werden.

4. Verfahren nach einem der vorhergehenden Ansprüche, wobei vor dem Aufbringen des mindestens einen Metalls (66) die Isolierschicht (58) auf zumindest einer Teilaußenseite der Außenseite des Halbleitersubstrats (50) und/oder der auf das Halbleitersubstrat (50) aufgebrachten Schicht gebildet wird und die mindestens eine Teilfläche (68) der Außenseite des Halbleitersubstrats (50) und/oder der auf das Halbleitersubstrat (50) aufgebrachten Schicht an mindestens einer Stelle des zu bildenden mindestens einen Kontakts (80) freigelegt wird.

5. Verfahren nach Anspruch 4, wobei zumindest eine Siliziumoxidschicht und/oder eine Siliziumnitridschicht als die Isolierschicht (58) gebildet werden.

6. Verfahren nach Anspruch 4 oder 5, wobei eine auf dem Halbleitersubstrat (50) abgeschiedene Gateoxidschicht (54) und eine die Gateoxidschicht (54) teilweise abdeckende Gatemetallisierungsschicht (56) von der Isolierschicht (58) abgedeckt werden.

7. Verfahren nach einem der vorhergehenden Ansprüche, wobei das Halbleitersubstrat (50) während des Erhitzens auf eine Temperatur von mindestens 600°C erwärmt wird.

8. Verfahren nach einem der vorhergehenden Ansprüche, wobei ein isotroper Ätzschritt als der Ätzschritt unter Verwendung des Ätzmaterials mit der höheren Ätzrate für das mindestens eine Metall (66) als für das Halbleiter-Metall-Material ausgeführt wird.

9. Verfahren nach einem der vorhergehenden Ansprüche, wobei mindestens ein Sourcekontakt als der mindestens eine Kontakt (80) gebildet wird.

## Claims

1. Method for forming a contact (80) on a semiconductor substrate (50) comprising the following steps:
applying at least one metal (66) to at least one exposed partial area (68) of an outer side of the semiconductor substrate (50) and/or a layer applied to the semiconductor substrate (50), wherein the partial area (68) is surrounded by at least one edge region (70) of an insulating layer (58), and wherein the at least one edge region (70) of the insulating layer (58) is at least partly covered with the at least one metal (66) (S1);
heating the semiconductor substrate (50) with the at least one metal (66) applied on the at least one partial area (68) and the at least one edge region (70), as a result of which the at least one metal (66) applied to the at least one partial area (68) reacts with at least one semiconductor material of the at least one partial area (68) to form a semiconductor-metal material as final material for further processing material of the at least one contact (80) (S3); and
carrying out an etching step using an etching material having a higher etching rate for the at least one metal (66) and for the semiconductor-metal material (S4),
**characterized by** the step that
between applying the at least one metal (66) and heating the semiconductor substrate (50), at least one ion beam etching step is carried out in an etching direction (72) which is inclined with respect to an axis (74) oriented perpendicularly to the outer side of the semiconductor substrate (50) .

2. Method according to Claim 1, wherein at least one of the contacts (80) is formed at a distance (a1) from at least one gate stack structure (52) which is less than 10 nm, wherein the gate stack structure (52) comprises a gate oxide layer (54) deposited on the semiconductor substrate (50), a gate metallization layer (56) partly covering the gate oxide layer (54), and the insulating layer (58) applied to the gate stack structure (52) and the gate metallization layer (56).

3. Method according to Claim 1 or 2, wherein nickel, titanium, aluminium, tantalum and/or tungsten are/is applied as the at least one metal (66).

4. Method according to any of the preceding claims, wherein, before applying the at least one metal (66), the insulating layer (58) is formed on at least one partial outer side of the outer side of the semiconductor substrate (50) and/or the layer applied to the semiconductor substrate (50) and the at least one partial area (68) of the outer side of the semiconductor substrate (50) and/or of the layer applied to the semiconductor substrate (50) is exposed at at least one location of the at least one contact (80) to be formed.

5. Method according to Claim 4, wherein at least one silicon oxide layer and/or one silicon nitride layer are/is formed as the insulating layer (58).

6. Method according to Claim 4 or 5, wherein a gate oxide layer (54) deposited on the semiconductor substrate (50) and a gate metallization layer (56) partly covering the gate oxide layer (54) are covered by the insulating layer (58).

7. Method according to any of the preceding claims, wherein the semiconductor substrate (50) is heated to a temperature of at least 600°C during the heating.

8. Method according to any of the preceding claims, wherein an isotropic etching step is carried out as the etching step using the etching material having the higher etching rate for the at least one metal (66) than for the semiconductor-metal material.

9. Method according to any of the preceding claims, wherein at least one source contact is formed as the at least one contact (80).

## Revendications

1. Procédé de formation d'un contact (80) sur un substrat en semiconducteur (50), comprenant les étapes suivantes :
application d'au moins un métal (66) sur au moins une surface partielle (68) libérée d'un côté extérieur du substrat en semiconducteur (50) et/ou sur une couche appliquée sur le substrat en semiconducteur (50), la surface partielle (68) étant encadrée par au moins une zone de bordure (70) d'une couche isolante (58), et l'au moins une zone de bordure (70) de la couche isolante (58) étant au moins partiellement recouverte par l'au moins un métal (66) (S1) ;
réchauffement du substrat en semiconducteur (50) avec l'au moins un métal (66) appliqué sur l'au moins une surface partielle (68) et l'au moins une zone de bordure (70), moyennant quoi l'au moins un métal (66) appliqué sur l'au moins une surface partielle (68) réagit avec au moins un matériau semiconducteur de l'au moins une surface partielle (68) pour former un matériau semiconducteur-métal en tant que matériau final ou matériau de post-traitement de l'au moins un contact (80) (S3) ; et
exécution d'une étape de gravure en utilisant un matériau de gravure ayant une vitesse de gravure plus élevée pour l'au moins un métal (66) que pour le matériau semiconducteur-métal (S4)
**caractérisé par** l'étape selon laquelle
au moins une étape de gravure par irradiation ionique est exécutée entre l'application de l'au moins un métal (66) et le chauffage du substrat en semiconducteur (50) dans une direction de gravure (72) qui est inclinée par rapport à un axe (74) orienté perpendiculairement par rapport au côté extérieur du substrat en semiconducteur (50) .

2. Procédé selon la revendication 1, au moins l'un des contacts (80) étant formé à une distance (a1) par rapport à au moins une structure d'empilement de gâchette (52), laquelle est plus petite que 10 nm, la structure d'empilement de gâchette (52) comportant une couche d'oxyde de gâchette (54) déposée sur le substrat en semiconducteur (50), une couche de métallisation de gâchette (56) qui recouvre partiellement la couche d'oxyde de gâchette (54) et une couche isolante (58) appliquée sur la structure d'empilement de gâchette (52) et la couche de métallisation de gâchette (56).

3. Procédé selon la revendication 1 ou 2, du nickel, du titane, de l'aluminium, du tantale et/ou du tungstène étant appliqués en tant que l'au moins un métal (66).

4. Procédé selon l'une des revendications précédentes, la couche isolante (58) étant formée sur au moins un côté extérieur partiel du côté extérieur du substrat en semiconducteur (50) et/ou de la couche appliquée sur le substrat en semiconducteur (50) avant l'application de l'au moins un métal (66) et l'au moins une surface partielle (68) du côté extérieur du substrat en semiconducteur (50) et/ou de la couche appliquée sur le substrat en semiconducteur (50) étant libérée au niveau d'au moins un emplacement de l'au moins un contact (80) à former.

5. Procédé selon la revendication 4, au moins une couche d'oxyde de silicium et/ou une couche de nitrure de silicium étant formée en tant que la couche isolante (58) .

6. Procédé selon la revendication 4 ou 5, une couche d'oxyde de gâchette (54) et une couche de métallisation de gâchette (56) qui recouvre partiellement la couche d'oxyde de gâchette (54) étant recouvertes par la couche isolante (58).

7. Procédé selon l'une des revendications précédentes, le substrat en semiconducteur (50) étant chauffé à une température d'au moins 600 °C pendant le réchauffement.

8. Procédé selon l'une des revendications précédentes, une étape de gravure isotrope étant exécutée en tant qu'étape de gravure en utilisant le matériau de gravure ayant la vitesse de gravure plus élevée pour l'au moins un métal (66) que pour le substrat en semiconducteur (50) .

9. Procédé selon l'une des revendications précédentes, au moins un contact de source étant formé en tant que l'au moins un contact (80).
